(19) Europäisches Patentamt
European Patent Office
Office européen des brevets

(11) **EP 2 414 439 B1**

(12) **FASCICULE DE BREVET EUROPEEN**

(45) Date de publication et mention de la délivrance du brevet:
**26.03.2014 Bulletin 2014/13**

(51) Int Cl.:
*C08J 5/00* ^(2006.01)     *C08L 65/00* ^(2006.01)
*C08J 3/215* ^(2006.01)    *C08J 5/18* ^(2006.01)
*C08J 7/04* ^(2006.01)     *C09D 165/00* ^(2006.01)
*H01L 51/44* ^(2006.01)

(21) Numéro de dépôt: **09784183.7**

(22) Date de dépôt: **31.03.2009**

(86) Numéro de dépôt international:
**PCT/FR2009/000373**

(87) Numéro de publication internationale:
**WO 2010/112680 (07.10.2010 Gazette 2010/40)**

(54) **FILMS OU REVETEMENTS TRANSPARENTS CONDUCTEURS**

TRANSPARENTE LEITFÄHIGE FILME ODER BESCHICHTUNGEN

TRANSPARENT CONDUCTIVE FILMS OR COATINGS

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(43) Date de publication de la demande:
**08.02.2012 Bulletin 2012/06**

(73) Titulaires:
• **Hutchinson**
  **75008 Paris (FR)**
• **Centre National de la Recherche Scientifique**
  **75016 Paris (FR)**
• **Université Louis Pasteur**
  **67000 Strasbourg (FR)**

(72) Inventeurs:
• **SONNTAG, Philippe**
  **F-77850 Héricy (FR)**
• **BERSON, Solenn**
  **F-73000 Chambéry (FR)**
• **BROCHON, Cyril**
  **33700 Mérignac (FR)**
• **DIEUDONNE, Marie**
  **F-12210 Laguiole (FR)**
• **HADZIIOANNOU, Georges**
  **F-33850 Léognan (FR)**
• **HEISER, Thomas**
  **F-67270 Hochfelden (FR)**

(74) Mandataire: **Mena, Sandra et al**
    **Cabinet Orès**
    **36, rue de St Pétersbourg**
    **75008 Paris (FR)**

(56) Documents cités:
EP-A1- 1 918 325       WO-A1-2005/090446
WO-A1-2008/055311      WO-A2-2007/002737
US-A1- 2004 021 131    US-A1- 2005 209 392
US-A1- 2006 041 104    US-A1- 2006 052 509
US-A1- 2006 062 983

• WANNA Y ET AL: "Development of nanofibers composite Polyaniine/CNT fabricated by Electro spinning Technique for CO Gas Sensor" SENSORS, 2006. 5TH IEEE CONFERENCE ON, IEEE, PI, 1 octobre 2006 (2006-10-01), pages 342-345, XP031083027 ISBN: 978-1-4244-0375-2
• HERMANT M C; KLUMPERMAN B; KYRYLYUK A V; VAN DER SCHOOT P; KONING C E: "Lowering the percolation threshold of single-walled carbon nanotubes using polystyrene/poly(3,4-ethylenedioxythiophen e): Poly(styrene sulfonate) blends" SOFT MATTER, vol. 5, 8 janvier 2009 (2009-01-08), pages 878-885, XP009124904

**Description**

La présente invention concerne une composition spécifique de nanotubes de carbone dispersés dans du poly(3,4-éthylènedioxythiophène)-poly(styrènesulfonate) (PEDOT : PSS), un film ou revêtement transparent conducteur résultant de la filmification ou du dépôt d'une telle composition, un procédé de préparation d'un tel film ou revêtement, et des articles et dispositifs électroniques revêtus de tels films ou revêtements.

Des électrodes transparentes conductrices présentant à la fois une transmittance et des propriétés de conductivité électrique élevées font actuellement l'objet de développements considérables dans le domaine des équipements électroniques, ce type d'électrodes étant de plus en plus utilisé pour des dispositifs tels que les cellules photovoltaïques, les écrans à cristaux liquides, les diodes électroluminescentes organiques (OLED) ou les diodes électroluminescentes polymériques (PLED), ainsi que les écrans tactiles.

Actuellement, les principaux films transparents conducteurs utilisés sont à base d'ITO (Indium Tin Oxide), ce composant présentant des propriétés de transmittance et de conductivité électrique particulièrement élevées. Toutefois, les procédés de dépôt de telles compositions nécessitent de travailler sous vide. De plus, un procédé généralement utilisé pour réaliser des couches d'ITO est la pulvérisation cathodique, dont l'inconvénient principal est la nécessité de travailler à haute température, typiquement à des températures de l'ordre de 200°C ou plus, cette étape de recuit thermique étant nécessaire pour améliorer la conductivité des films obtenus. Ainsi, ces exigences de procédé ne permettent pas l'application des compositions à base d'ITO sur de grandes surfaces, ni sur des substrats flexibles, tels que les polymères. D'autre part, l'ITO est un constituant rigide qui, lorsqu'il est appliqué sur des substrats flexibles crée des contraintes de surface conduisant à l'apparition de fissurations et de trous à la surface du film, diminuant ainsi la durée de vie des substrats revêtus.

Enfin, un autre inconvénient de ces compositions est la rareté du minéral indium, conduisant à des compositions à base d'ITO de plus en plus coûteuses.

Pour remédier à tous ces inconvénients, il a été proposé la mise au point de films conducteurs transparents à base de nanotubes de carbone, ces derniers pouvant être préparés à partir de dispersions à base de nanotubes de carbone. Toutefois, la préparation de telles dispersions nécessite l'utilisation de dispersants (les nanotubes de carbone étant difficiles à disperser seuls), ces derniers étant des matériaux organiques isolants qui, une fois incorporés à la composition, diminuent fortement la conductivité du film obtenu. Pour remédier à ce problème, il a été proposé de laver les films obtenus afin d'éliminer une partie du dispersant utilisé (l'élimination totale du dispersant étant très difficile), cette étape rendant toutefois le procédé utilisé plus difficile à mettre en oeuvre.

Certaines solutions de l'état de l'art proposent également de substituer l'ITO par des mélanges de nanotubes de carbone dispersés dans des polymères conducteurs. Toutefois, il apparaît que les polymères conducteurs utilisés détériorent considérablement la transparence du film, ces derniers présentant généralement l'inconvénient d'être très colorés et peu transparents. Ainsi, seules des couches très minces, dont il est difficile de contrôler l'épaisseur, peuvent être déposées sur les substrats (l'épaisseur de ces couches ne pouvant pas dépasser 200 à 300 nm), ces dépôts d'épaisseur très fine nécessitant des substrats de très faible rugosité (rugosité arithmétique Ra < 50 nm). C'est le cas des compositions divulguées dans les documents WO 2006/137846 et US 6,984,341, ce dernier document divulguant notamment des compositions obtenues à partir d'une dispersion aqueuse de polythiophène et d'un composé polyanionique, tel qu'un polystyrène sulfonate, en présence d'un additif supplémentaire choisi parmi les cétals, lactones, carbonates, oxydes cycliques, dicétones, anhydrides, acides aminocarboniques, phénols et acides inorganiques.

Ainsi, le problème technique restant à résoudre par rapport à cet état de l'art consiste en la mise au point de films ou de revêtements conducteurs pouvant être appliqués en couches épaisses (pouvant aller jusqu'à 5-10 $\mu$m), sans altération de la transparence, ni de la conductivité électrique du film, et ne nécessitant pas la mise en oeuvre de procédés spécifiques complexes.

Les compositions de nanotubes de carbone de l'invention, et les films ou revêtements transparents conducteurs résultant de la filmification ou du dépôt desdites compositions, proposent de remédier à tous ces inconvénients, en répondant de manière satisfaisante aux besoins et exigences suivantes :

- une bonne conductivité électrique,
- une transparence plus élevée que celle des films de l'état de l'art,
- une excellente souplesse des films obtenus comparée à celle des films de l'état de l'art, diminuant ainsi les risques de détérioration et de fissuration des surfaces revêtues,

- une excellente stabilité au stockage des compositions,
- une plus grande facilité de mise en oeuvre et une meilleure manipulation des compositions de l'invention, ces dernières pouvant être appliquées en couches épaisses, sans altération des propriétés de transparence des films obtenus, et les procédés mis en oeuvre pouvant fonctionner à pression atmosphérique, et permettant ainsi des dépôts sur de grandes surfaces,

- une application sur une plus grande variété de substrats, les procédés d'application des compositions de l'invention ne nécessitant pas de traitement thermique à haute température, et permettant ainsi une application sur des substrats flexibles sensibles à la chaleur, et
- des avantages économiques, du fait de la substitution de l'indium, composé rare et de plus en plus coûteux.

Il s'agit en fait d'un compromis de performances difficile à atteindre, tous ces avantages étant obtenus sans affecter négativement les propriétés électriques du film ou du revêtement conducteur obtenu, voire même en apportant dans certains cas des améliorations significatives en termes de transparence et de transmittance.

Ainsi, par rapport aux films de l'état de l'art antérieur, les films ou revêtements transparents conducteurs de l'invention, présentent un excellent compromis de performances, à priori difficile à obtenir, et ce grâce à une composition de nanotubes de carbone spécifique comprenant au moins une dispersion ou suspension d'élastomère.

Le premier objet de la présente invention est donc une composition de nanotubes de carbone dispersés dans du PEDOT : PSS en dispersion ou en suspension dans de l'eau et/ou dans un solvant, cette composition ayant comme caractéristique spécifique essentielle la présence supplémentaire d'au moins une dispersion ou suspension d'élastomère sélectionné parmi les copolymères isobutylène/isoprène et les copolymères butadiène / acrylonitrile.

Le deuxième objet de l'invention concerne un film ou revêtement transparent conducteur résultant de la filmification ou du dépôt d'au moins une composition selon l'invention.

Un objet supplémentaire de l'invention est un procédé de préparation du film ou revêtement transparent conducteur de l'invention.

Enfin, font également partie de l'invention un article comportant un substrat revêtu d'un film ou revêtement transparent conducteur selon l'invention, ainsi qu'un dispositif électronique comprenant un tel article revêtu d'un tel film ou revêtement transparent conducteur.

Ainsi, le premier objet de la présente invention est une composition de nanotubes de carbone dispersés dans du PEDOT : PSS en dispersion ou en suspension dans de l'eau et/ou dans un solvant, et ladite composition comprenant en outre au moins une dispersion ou suspension d'élastomère sélectionné parmi les copolymères isobutylène/isoprène et les copolymères butadiène/acrylonitrile.

Les nanotubes de carbone de la présente invention peuvent être présents à un taux en poids compris entre 0,05 et 90%, et de préférence à un taux en poids compris entre 0,1 et 10%, par rapport au poids total de matière sèche de ladite composition.

Les nanotubes de carbone de l'invention peuvent être en dispersion ou en suspension dans de l'eau et/ou dans un solvant, ledit solvant pouvant être un solvant organique polaire sélectionné parmi le diméthylsulfoxyde (DMSO), le N-méthyl-2-pyrrolidone (NMP), le diméthylformamide (DMF), le diméthylacétate (DMAc), l'éthylène glycol, l'acétone, les alcools tels que le méthanol, l'éthanol, le butanol et l'isopropanol, ou un mélange desdits solvants. De préférence, les nanotubes de carbone de l'invention sont dispersés dans de l'eau ou dans un mélange eau/solvant organique polaire, et de préférence un mélange eau/diméthylsulfoxyde (DMSO) ou un mélange eau/éthanol.

Les nanotubes de carbone utilisés peuvent être des nanotubes mono-et/ou multi-parois, purifiés ou non purifiés, fonctionnalisés ou non fonctionnalisés, lesdits nanotubes de carbone pouvant être obtenus selon n'importe quelle méthode de fabrication connue, telles que les méthodes par ablation laser, CVD (Chemical Vapor Deposition), ou décharge d'arc. De préférence, on utilise les nanotubes de carbone présentant le moins d'impuretés possible, de façon à obtenir une meilleure transparence et une meilleure qualité de film.

Selon un mode de réalisation préféré, les nanotubes de carbone de l'invention ont une longueur comprise entre 20 nm et 1 mm, et un diamètre compris entre 0,5 et 50 nm. Lesdits nanotubes peuvent se présenter soit sous forme individuelle, soit sous forme de fagots.

La composition selon la présente invention comprend comme constituant essentiel au moins un élastomère sélectionné parmi les copolymères isobutylène/isoprène et les copolymères butadiène/acrylonitrile, introduit sous la forme d'une dispersion ou d'une suspension dans de l'eau et/ou dans un solvant, ledit élastomère étant choisi en fonction des contraintes d'application finales visées.

De manière préférée, la composition selon la présente invention comprend une dispersion ou suspension d'élastomère sélectionné parmi les copolymères isobutylène/isoprène et les copolymères butadiène/acrylonitrile, ledit élastomère pouvant être réticulable, ou éventuellement être déjà partiellement ou totalement réticulé. Le système de réticulation utilisé peut être soit un système de vulcanisation au soufre, soit un système de réticulation à base de peroxyde, éventuellement en combinaison avec du soufre. Selon une autre variante, la composition de nanotubes de carbone de l'invention peut comprendre un élastomère comportant des groupements thermoréticulables, ou encore un élastomère thermoplastique déjà réticulé.

Ledit élastomère peut être choisi parmi les copolymères isobutylène/isoprène, qui incluent le butyle caoutchouc (butyl rubber), et les copolymères butadiène/acrylonitrile.

Selon un mode de réalisation préféré, le ratio en poids entre ledit élastomère et les nanotubes de carbone est compris entre 10 et 10000. Le ratio en poids entre ledit élastomère et le PEDOT : PSS peut, quant à lui, être compris entre 1 et 500000.

Ledit élastomère est utilisé sous la forme d'une dispersion ou d'une suspension dans de l'eau et/ou dans un solvant, ledit solvant pouvant être un solvant organique polaire sélectionné parmi le diméthylsulfoxyde (DMSO), le N-methyl-2-pyrrolidone (NMP), le diméthylformamide (DMF), le diméthylacétate (DMAc), l'éthylène glycol, l'acétone, les alcools tels que le méthanol, l'éthanol, le butanol et l'isopropanol, ou un mélange desdits solvants. De préférence, l'élastomère de l'invention est en dispersion ou en suspension dans de l'eau.

Une autre caractéristique essentielle de la composition de l'invention concerne le polymère conducteur PEDOT : PSS dans lequel sont dispersés les nanotubes de carbone, ledit PEDOT : PSS étant stable à la lumière et à la chaleur, facile à disperser dans l'eau, et ne présentant pas de problèmes au stockage, ni d'inconvénients environnementaux.

De manière préférée, le ratio en poids entre les nanotubes de carbone et le PEDOT : PSS de la composition de l'invention est compris entre 1/100 et 50/ 1, et de préférence entre 1/50 et 5/1.

Le PEDOT : PSS de l'invention peut être en dispersion ou en suspension dans de l'eau et/ou dans un solvant, ledit solvant pouvant être un solvant organique polaire sélectionné parmi le diméthylsulfoxyde (DMSO), le N-méthyl-2-pyrrolidone (NMP), le diméthylformamide (DMF), le diméthylacétate (DMAc), l'éthylène glycol, l'acétone, les alcools tels que le méthanol, l'éthanol, le butanol et l'isopropanol, ou un mélange desdits solvants. De préférence, le PEDOT : PSS de l'invention est dispersé dans de l'eau et/ou dans un mélange eau/diméthylsulfoxyde (DMSO).

Des composés organiques ou « conductivity enhancers» permettant d'améliorer la conductivité du PEDOT : PSS peuvent également être ajoutés, dans le but d'augmenter la conductivité électrique du PEDOT : PSS. De tels composés peuvent être porteurs de groupements dihydroxy ou polyhydroxy et/ ou carboxy ou amide ou lactame, comme le sorbitol ou la glycérine, tel que suggéré dans le brevet US 5,766,515. Plus particulièrement, le brevet US 6,984,341 propose l'ajout de composés phénoliques permettant d'améliorer la conductivité des polythiophènes.

La concentration de la composition de l'invention en matière active, c'est-à-dire en matière sèche de nanotubes de carbone, de PEDOT : PSS et d'élastomère, par rapport au total de solvant peut être comprise entre 5 et 60%.

Des additifs, tels que des tensioactifs, des agents anti-moussants, des agents rhéologiques, tels que des agents épaississants ou des agents fluidifiants, des agents protecteurs anti-UV, des antioxydants, des promoteurs d'adhésion, des plastifiants, des colorants, des agents réticulants, des particules manométriques conductrices ou métalliques, peuvent également être ajoutés à la composition pour améliorer la formulation de la composition de nanotubes de carbone de l'invention.

Un objet supplémentaire de la présente invention est un film ou revêtement transparent conducteur résultant de la filmification ou du dépôt d'au moins une composition de nanotubes de carbone telle que définie selon la présente invention. La composition de l'invention peut ainsi soit être utilisée sous forme de film autosupporté, soit être déposée sur un support, selon n'importe quelle méthode connue de l'homme de l'art, les techniques les plus utilisées étant le spray coating, le dépôt au jet d'encre, le dépôt au trempé, le dépôt au tire-film, le dépôt au spin-coater, le dépôt par imprégnation, le dépôt par slot-die, le dépôt à la racle, ou la flexogravure.

Selon un mode de réalisation préféré, le film ou revêtement transparent conducteur de l'invention consiste en un polymère réticulé dans lequel des nanotubes de carbone sont répartis de façon sensiblement homogène. Ledit film ou revêtement présente, de préférence, une épaisseur comprise entre 300 nm et 15 $\mu$m.

De manière préférée, ledit film ou revêtement transparent conducteur présente une transmission totale de la lumière UV-visible [300 nm - 900 nm] d'au moins 30%, obtenue pour une épaisseur de film de 15 $\mu$m maximum. Ladite transmission est mesurée selon la méthode exemplifiée ci-après dans la partie expérimentale.

La résistance de surface du film ou revêtement transparent conducteur de l'invention peut varier entre 0,1 et 5000 ohms/carré ($\Omega/\square$), et de préférence entre 0,1 et 1000 $\Omega/\square$. Ladite résistance de surface est mesurée selon la méthode exemplifiée ci-après dans la partie expérimentale.

Un autre objet de l'invention concerne un procédé de préparation d'un film ou revêtement transparent conducteur tel que défini précédemment, ledit procédé comprenant les étapes suivantes :

(i) dispersion des nanotubes de carbone dans de l'eau et/ou dans un solvant, ledit solvant pouvant être un solvant organique polaire sélectionné parmi le diméthylsulfoxyde (DMSO), le N-méthyl-2-pyrrolidone (NMP), le diméthylformamide (DMF), le diméthylacétate (DMAc), l'éthylène glycol, l'acétone, les alcools tels que le méthanol, l'éthanol, le butanol et l'isopropanol, ou un mélange desdits solvants,

(ii) mélange de la dispersion obtenue à l'étape (i) avec du PEDOT : PSS en dispersion ou en solution dans de l'eau et/ou dans un solvant, ledit solvant pouvant être un solvant organique polaire miscible au solvant utilisé lors de l'étape {i}, sélectionné parmi le diméthylsulfoxyde (DMSO), le N-méthyl-2-pyrrolidone (NMP), le diméthylformamide (DMF), le diméthylacétate (DMAc), l'éthylène glycol, l'acétone, les alcools tels que le méthanol, l'éthanol, le butanol et l'isopropanol, ou un mélange desdits solvants,

(iii) mélange de la dispersion obtenue à l'étape (ii) avec au moins un élastomère sélectionné parmi les copolymères isobutylène/isoprène tels que le butyle caoutchouc et les copolymères butadiène/acrylonitrile, en dispersion ou en suspension dans de l'eau et/ou dans un solvant, ledit solvant pouvant être un solvant organique polaire miscible aux solvants utilisés lors des étapes (i) et (ii), sélectionné parmi le diméthylsulfoxyde (DMSO), le N-méthyl-2-pyrrolidone (NMP), le diméthylformamide (DMF), le diméthylacétate (DMAc), l'éthylène glycol, l'acétone, les alcools tels que le méthanol, l'éthanol, le butanol et l'isopropanol, ou un mélange desdits solvants,

(iv) application de la composition obtenue à l'étape (iii) sur un support, et

(v) évaporation des solvants par séchage à une température comprise entre 20 et 180°C, pendant une durée comprise entre 5 secondes et 120 minutes.

De préférence, lors de l'étape (i) les nanotubes de carbone de l'invention sont dispersés dans de l'eau ou dans un mélange eau/solvant organique polaire, et de préférence un mélange eau/diméthylsulfoxyde (DMSO) ou un mélange eau/éthanol, lors de l'étape (ii) le PEDOT : PSS est dispersé dans de l'eau ou dans un mélange eau/diméthylsulfoxyde (DMSO), et lors de l'étape (iii) l'élastomère est dispersé dans de l'eau.

La présente invention couvre aussi un article comportant un substrat revêtu d'au moins un film ou revêtement transparent conducteur tel que défini précédemment, ou obtenu selon le procédé décrit ci-dessus, ledit substrat pouvant être constitué d'un matériau choisi parmi le verre, le métal, la céramique, les matériaux conducteurs ou semi-conducteurs et les polymères flexibles. L'article de l'invention peut être revêtu d'une ou de plusieurs couches dudit film ou revêtement transparent conducteur tel que défini selon l'invention.

Ainsi, le film ou revêtement transparent conducteur de l'invention peut être déposé sur tout article comportant un substrat flexible ou rigide, ledit substrat pouvant être transparent, translucide, opaque ou coloré.

Parmi les substrats flexibles, on trouve notamment les substrats polymères, ces derniers étant choisis en fonction de leur compatibilité avec le film ou revêtement transparent conducteur, de leur facilité d'utilisation, mais surtout en fonction des propriétés requises par l'application finale visée (tenue à des températures élevées, tenue au vieillissement...). Ainsi, les substrats polymères flexibles sont de préférence choisis parmi le polyéthylène téréphtalate (PET), le polyéthylène naphtalate (PEN), le polyéthersulfone (PES), le polycarbonate (PC), le polysulfone (PSU), les résines phénoliques, époxys, polyesters, polyimides, polyétheresters, polyétheramides, le polyvinyl(acétate), le nitrate de cellulose, l'acétate de cellulose, le polystyrène, les polyoléfines, le polyamide, les polyuréthanes aliphatiques, le polyacrylonitrile, le polytétrafluoroéthylène (PTFE), le polyméthyl méthacrylate (PMMA), le polyarylate, les polyétherimides, les polyéthers cétones (PEK), les polyéthers éthercétones (PEEK) et le polyfluorure de vinylidène (PVDF). Le polyéthylène téréphtalate (PET), le polyéthylène naphtalate (PEN) et le polyéthersulfone (PES) sont les substrats polymères flexibles les plus préférés.

Le film ou revêtement transparent conducteur de l'invention peut être déposé sur l'article comportant le substrat à revêtir selon n'importe quelle méthode de dépôt connue de l'homme de l'art, les techniques les plus utilisées étant le spray coating, le dépôt au jet d'encre, le dépôt au trempé, le dépôt au tire-flm, le dépôt au spin-coater, le dépôt par imprégnation, le dépôt par slot-die, ou la flexogravure.

Enfin, un dernier objet concerne un dispositif électronique comprenant au moins un article tel que défini selon la présente invention, ledit dispositif étant choisi parmi les cellules photovoltaïques, les écrans à cristaux liquides, les électrodes utilisées dans des dispositifs d'émission de lumière, tels que les diodes électroluminescentes organiques (OLED) ou les diodes électroluminescentes polymériques (PLED) et les écrans tactiles. De façon générale, les dispositifs électroniques de l'invention peuvent concernés tous types de dispositifs électroniques de l'état de l'art comprenant au moins une surface conductrice.

L'invention est maintenant décrite plus en détails au regard des exemples qui suivent. Il doit être bien entendu, toutefois, que ces exemples sont donnés uniquement à titre d'illustration de l'objet de l'invention, dont ils ne constituent en aucune manière une limitation.

I/ Matières premières

**Tableau I:**

| Composé | Nature chimique | Fournisseur |
|---|---|---|
| MWNTs Graphistrength C100® | Nanotubes de carbone | Arkema |

(suite)

| Composé | Nature chimique | Fournisseur |
|---------|-----------------|-------------|
| DMSO | diméthylsulfoxyde | Sigma-Aldrich |
| Clevios PH500® | Dispersion poly(3,4-éthylénedioxythiophène)-poly(styrènesulfonate) (PEDOT : PSS) | HC Starck |
| Synthomer 5130® | Elastomère butadiène / acrylonitrile | Synthomer |

II / Méthodes de caractérisation

1- Mesure de l'épaisseur du film

L'épaisseur des films transparents conducteurs est mesurée à l'aide d'un profilomètre mécanique Dektak 3030ST.

2- Mesure de la transmission de lumière

La transmission de lumière est mesurée à l'aide d'un spectrophotomètre Shimadzu UV 2101 PC sur un spectre UV-visible [300 nm - 900 nm].

3- Mesure de la résistance de surface

La résistance de surface (en $\Omega/\square$) peut être définie par la formule suivante :

$$R = \frac{\rho}{e} = \frac{1}{\sigma.e}$$

$e$ : épaisseur de la couche conductrice (en cm),
$\sigma$ : conductivité de la couche (en S/cm) ($\sigma$ = 1/p),
$\rho$ : résistivité de la couche (en $\Omega$. cm).

La résistance de surface est mesurée à l'aide d'un appareil 4-pointes, modèle Lucas Lab système Pro4. Des contacts en or sont déposés au niveau du contact avec les pointes, afin de faciliter les mesures.

Exemple 1 :

Une composition A est préparée de la façon suivante :

On disperse 2,5 mg de nanotubes de carbone MWNTs Graphistrength C100® dans 2,5 mL de DMSO à l'aide d'un bain ultrasons pendant 1 heure. On ajoute ensuite 2,5 mL d'une dispersion PEDOT : PSS Clevios PH 500® (HC Starck) ayant un extrait sec de 1,2%, puis on agite au bain ultrasons pendant 1 heure.

Dans 1 g d'un élastomère NBR (acrylonitrile-butadiene rubber) Synthomer 5130® en suspension dans l'eau (extrait sec de 45%), on ajoute 2,25 mL de la dispersion précédemment préparée, et on agite le mélange à l'aide d'un barreau aimanté pendant ½ heure.

La composition A préparée présente un ratio en poids nanotubes de carbone/PEDOT : PSS de 1/12, un pourcentage en poids de nanotubes de carbone de 0,25% par rapport à la masse de latex sec, et un extrait sec de 15%.

A l'aide de la composition A obtenue, on réalise un film d'épaisseur sèche (épaisseur finale) de 12 $\mu$m à l'aide d'un tire-film sur une plaque de verre, puis on sèche le film dans une étuve sous vide pendant 30 minutes, avec une rampe de température allant de 25 à 60°C.

Les propriétés du film transparent obtenu sont les suivantes :

- résistance de surface : R = 11 $\Omega/\square$,
- transmittance : T = 38% à 550 nm.

Exemple 2 :

Une composition B est préparée de la façon suivante :

On disperse 2,5 mg de nanotubes de carbone MWNTs Graphistrength C100® dans 2,5 mL de DMSO à l'aide d'un bain ultrasons pendant 1 heure. On ajoute ensuite 2,5 mL d'une dispersion PEDOT : PSS Clevios PH 500® (HC Starck) ayant un extrait sec de 1,2%, puis on agite au bain ultrasons pendant 1 heure.

Dans 1 g d'un élastomère NBR (acrylonitrile-butadiene rubber) Synthomer 5130® en suspension dans l'eau (extrait sec de 45%), on ajoute 2,25 mL de la dispersion précédemment préparée, et on agite le mélange à l'aide d'un barreau aimanté pendant ½ heure.

La composition B préparée présente un ratio en poids nanotubes de carbone/PEDOT : PSS de 1/12, un pourcentage en poids de nanotubes de carbone de 0,25% par rapport à la masse de latex sec, et un extrait sec de 15%.

A l'aide de la composition B obtenue, on réalise un film d'épaisseur sèche (épaisseur finale) de 1,5 $\mu$m à l'aide d'un tire-film sur une plaque de verre, puis on sèche le film dans un four pendant 5 minutes, avec une rampe de température allant de 25 à 60°C.

Les propriétés du film transparent obtenu sont les suivantes :

- résistance de surface : R = 407 $\Omega/\square$,
- transmittance : T = 69% à 550 nm.

Contre-exemple 1 : (sans ajout d'élastomère)

Une composition C est préparée de la façon suivante :

On pèse dans un pilulier 5 mg de nanotubes de carbone MWNTs Graphistrength C100®, puis on y ajoute 1 mL d'une dispersion PEDOT : PSS Clevios PH 500® (HC Starck) et 5% en poids de DMSO (0,05 mL).

Le mélange est ensuite dispersé à l'aide d'une sonde à ultrasons pendant 30 minutes.

La composition C préparée présente un ratio en poids nanotubes de carbone/PEDOT : PSS de 1/2,4, un pourcentage en poids de nanotubes de carbone de 45% par rapport à la masse sèche totale, et un extrait sec de 0,6%.

A l'aide de la composition C obtenue, on réalise un film d'épaisseur sèche de 2,5 $\mu$m à l'aide d'un tire-film sur une plaque de verre, puis on sèche le film dans une étuve sous vide pendant 30 minutes, avec une rampe de température allant de 25 à 60°C.

Les propriétés du film transparent obtenu sont les suivantes :

- résistance de surface : R = 10 $\Omega/\square$,
- transmittance : T = 0% à 550 nm.

Contre-exemple 2 : (sans ajout d'élastomère)

Une composition D est préparée de la façon suivante :

On pèse dans un pilulier 1 mg de nanotubes de carbone MWNTs Graphistrength C100®, puis on y ajoute 1 mL d'une dispersion PEDOT : PSS Clevios PH 500® (HC Starck) et 1 mL de DMSO.

Le mélange est ensuite dispersé à l'aide d'une sonde à ultrasons pendant 1 heure.

La composition D préparée présente un ratio en poids nanotubes de carbone/PEDOT: PSS de 1/12, un pourcentage en poids de nanotubes de carbone de 29% par rapport à la masse totale sèche, et un extrait sec de 1,6%.

A l'aide de la composition D obtenue, on réalise un film d'épaisseur sèche de 25 nm à l'aide d'un spin-coater sur une plaque de verre, la réalisation d'un film épais étant impossible, puis on sèche le film dans une étuve sous vide pendant 30 minutes, avec une rampe de température allant de 25 à 60°C.

Les propriétés du film obtenu sont les suivantes :

- résistance de surface : R = 2. $10^5$ $\Omega/\square$,
- transmittance : T = 98% à 550 nm.

**Revendications**

1. Composition de nanotubes de carbone dispersés dans du poly(3,4-éthylènedioxythiophène)-poly(styrènesulfonate) (PEDOT : PSS), ledit PEDOT : PSS étant en dispersion ou en suspension dans de l'eau et/ou dans un solvant, **caractérisée en ce que** ladite composition comprend en outre au moins une dispersion ou suspension d'élastomère sélectionné parmi les copolymères isobutylène/isoprène tels que le butyle caoutchouc, et les copolymères butadiéne/acrylonitrile.

**2.** Composition selon la revendication 1 **caractérisée en ce que** le ratio en poids entre les nanotubes de carbone et le PEDOT : PSS est compris entre 1/100 et 50/1, et de préférence entre 1/50 et 5/1.

**3.** Composition selon l'une des revendications 1 ou 2 **caractérisée en ce que** les nanotubes de carbone sont présents à un taux en poids compris entre 0,05 et 90%, et de préférence entre 0,1 et 10%, par rapport au poids total de matière sèche de ladite composition.

**4.** Composition selon l'une des revendications 1 à 3 **caractérisée en ce que** le ratio en poids entre ledit élastomère et lesdits nanotubes de carbone est compris entre 10 et 10000.

**5.** Composition selon l'une des revendications 1 à 4 **caractérisée en ce que** le ratio en poids entre ledit élastomère et le PEDOT : PSS est compris entre 1 et 500000.

**6.** Film ou revêtement transparent conducteur **caractérisé en ce qu'**il résulte de la filmification ou du dépôt d'au moins une composition de nanotubes de carbone telle que définie selon l'une des revendications 1 à 5.

**7.** Film ou revêtement selon la revendication 6 **caractérisé en ce qu'**il présente une épaisseur comprise entre 300 nm et 15 $\mu$m.

**8.** Film ou revêtement selon l'une des revendications 6 ou 7 **caractérisé en ce qu'**il présente une transmission totale de la lumière UV-visible [300 nm - 900 nm] d'au moins 30%, pour une épaisseur de film de 15 $\mu$m maximum.

**9.** Film ou revêtement selon l'une des revendications 6 à 8 **caractérisé en ce qu'**il présente une résistance de surface comprise entre 0,1 et 5000 $\Omega/\square$, et de préférence entre 0,1 et 1000 $\Omega/\square$.

**10.** Procédé de préparation d'un film ou revêtement transparent conducteur tel que défini selon l'une des revendications 6 à 9 **caractérisé en ce qu'**il comprend les étapes suivantes :

(i) dispersion des nanotubes de carbone dans de l'eau et/ou dans un solvant, ledit solvant pouvant être un solvant organique polaire sélectionné parmi le diméthylsulfoxyde (DMSO), le N-méthyl-2-pyrrolidone (NMP), le diméthylformamide (DMF), le diméthylacétate (DMAc), l'éthylène glycol, l'acétone, les alcools tels que le méthanol, l'éthanol, le butanol et l'isopropanol, ou un mélange desdits solvants,

(ii) mélange de la dispersion obtenue à l'étape (i) avec du poly(3,4-éthylènedioxythiophène)-poly(styrènesulfonate) (PEDOT: PSS) en dispersion ou en solution dans de l'eau et/ou dans un solvant, ledit solvant pouvant être un solvant organique polaire miscible au solvant utilisé lors de l'étape (i), sélectionné parmi le diméthylsulfoxyde (DMSO), le N-méthyl-2-pyrrolidone (NMP), le diméthylformamide (DMF), le diméthylacétate (DMAc), l'éthylène glycol, l'acétone, les alcools tels que le méthanol, l'éthanol, le butanol et l'isopropanol, ou un mélange desdits solvants,

(iii) mélange de la dispersion obtenue à l'étape (ii) avec au moins un élastomère sélectionné parmi les copolymères isobutylène/isoprène tels que le butyle caoutchouc, et les copolymères butadiène/acrylonitrile en dispersion ou en suspension dans de l'eau et/ou dans un solvant, ledit solvant pouvant être un solvant organique polaire miscible aux solvants utilisés lors des étapes (i) et (ii), sélectionné parmi le diméthylsulfoxyde (DMSO), le N méthyl-2-pyrrolidone (NMP), le diméthylformamide (DMF), le diméthylacétate (DMAc), l'éthylène glycol, l'acétone, les alcools tels que le méthanol, l'éthanol, le butanol et l'isopropanol, ou un mélange desdits solvants,

(iv) application de la composition obtenue à l'étape (iii) sur un support, et

(v) évaporation des solvants par séchage à une température comprise entre 20 et 180°C, pendant une durée comprise entre 5 secondes et 120 minutes.

**11.** Procédé selon la revendication 10 **caractérisé en ce que** les nanotubes de carbone de l'invention sont dispersés dans de l'eau ou dans un mélange eau/diméthylsulfoxyde (DMSO) ou dans un mélange eau/éthanol lors de l'étape (i), le PEDOT : PSS est dispersé dans de l'eau ou dans un mélange eau/diméthylsulfoxyde (DMSO) lors de l'étape (ii), et l'élastomère est dispersé dans de l'eau lors de l'étape (iii).

**12.** Article **caractérisé en ce qu'**il comporte un substrat revêtu d'au moins un film ou revêtement transparent conducteur tel que défini selon l'une des revendications 6 à 9 ou obtenu selon le procédé tel que défini à l'une des revendications 1.0 ou 11.

**13.** Article selon la revendication 12 **caractérisé en ce que** le substrat est choisi parmi le verre, le métal, la céramique, les matériaux conducteurs ou semi-conducteurs et les polymères flexibles.

**14.** Article selon la revendication 13 **caractérisé en ce que** lesdits polymères flexibles sont sélectionnés parmi le polyéthylène téréphtalate (PET), le polyéthylène naphtalate (PEN) et le polyéthersulfone (PES).

**15.** Dispositif électronique **caractérisé en ce qu'**il comprend au moins un article tel que défini selon l'une des revendications 12 à 14.

**16.** Dispositif selon la revendication 15 **caractérisé en ce qu'**il est choisi parmi les cellules photovoltaïques, les écrans à cristaux liquides, les diodes électroluminescentes organiques (OLED), les diodes électroluminescentes polymériques (PLED) et les écrans tactiles.

**Patentansprüche**

**1.** Zusammensetzung von in Poly-3,4-ethylendioxythiophen-Polystyrolsulfonat (PEDOT : PSS) dispergierten Kohlenstoffnanoröhren, wobei das PEDOT : PSS in Dispersion oder in Suspension in Wasser und/oder in einem Lösemittel vorliegt, **dadurch gekennzeichnet, dass** die Zusammensetzung weiterhin wenigstens eine Elastomerdispersion oder -suspension umfasst, ausgewählt aus Isobutylen/Isopren-Copolymeren wie Butylkautschuk und Butadien/Acrylnitril-Copolymeren.

**2.** Zusammensetzung nach Anspruch 1, **dadurch gekennzeichnet, dass** das Gewichtsverhältnis zwischen den Kohlenstoffnanoröhren und dem PEDOT : PSS zwischen 1/100 und 50/1, vorzugsweise zwischen 1/50 und 5/1, liegt.

**3.** Zusammensetzung nach einem der Ansprüche 1 oder 2, **dadurch gekennzeichnet, dass** die Kohlenstoffnanoröhren in einem Gewichtanteil zwischen 0,05 und 90%, vorzugsweise zwischen 0,1 und 10%, vorliegen, bezogen auf das Gesamtgewicht der Trockenmasse der Zusammensetzung.

**4.** Zusammensetzung nach einem der Ansprüche 1 bis 3, **dadurch gekennzeichnet, dass** das Gewichtsverhältnis zwischen dem Elastomer und den Kohlenstoffnanoröhren zwischen 10 und 10000 liegt.

**5.** Zusammensetzung nach einem der Ansprüche 1 bis 4, **dadurch gekennzeichnet, dass** das Gewichtsverhältnis zwischen dem Elastomer und dem PEDOT : PSS zwischen 1 und 500000 liegt.

**6.** Leitfähige transparente Folie oder Beschichtung, **dadurch gekennzeichnet, dass** sie aus der Filmbildung oder Abscheidung wenigstens einer Zusammensetzung von Kohlenstoffnanoröhren gemäß einem der Ansprüche 1 bis 5 resultiert.

**7.** Folie oder Beschichtung nach Anspruch 6, **dadurch gekennzeichnet, dass** sie eine Dicke zwischen 300 nm und 15 $\mu$m aufweist.

**8.** Folie oder Beschichtung nach einem der Ansprüche 6 oder 7, **dadurch gekennzeichnet, dass** sie eine Gesamtdurchlässigkeit für UV-Licht im sichtbaren Bereich [300 nm - 900 nm] von wenigstens 30% bei einer Foliendicke von höchstens 15 $\mu$m aufweist.

**9.** Folie oder Beschichtung nach einem der Ansprüche 6 bis 8, **dadurch gekennzeichnet, dass** sie einen Flächenwiderstand zwischen 0,1 und 5000 $\Omega/\square$ und vorzugsweise zwischen 0,1 und 1000 $\Omega/\square$ aufweist.

**10.** Verfahren zur Herstellung einer leitfähigen transparenten Folie oder Beschichtung gemäß einem der Ansprüche 6 bis 9, **dadurch gekennzeichnet, dass** es die folgenden Schritte umfasst:

(i) Dispersion der Kohlenstoffnanoröhren in Wasser und/oder in einem Lösemittel, wobei das Lösemittel ein polares organisches Lösemittel sein kann, ausgewählt aus Dimethylsulfoxid (DMSO), N-Methyl-2-pyrrolidon (NMP), Dimethylformamid (DMF), Dimethylacetat (DMAc), Ethylenglycol, Aceton, Alkoholen wie Methanol, Ethanol, Butanol und Isopropanol, oder einer Mischung dieser Lösemittel,
(ii) Mischen der in Schritt (i) erhaltenen Dispersion mit Poly-3,4-ethylendioxythiophen-Polystyrolsulfonat (PEDOT : PSS) in Dispersion oder Lösung in Wasser und/oder in einem Lösemittel, wobei das Lösemittel ein mit dem in Schritt (i) verwendeten Lösemittel mischbares polares organisches Lösemittel sein kann, ausgewählt aus Dimethylsulfoxid (DMSO), N-Methyl-2-pyrrolidon (NMP), Dimethylformamid (DMF), Dimethylacetat (DMAc), Ethylenglycol, Aceton, Alkoholen wie Methanol, Ethanol, Butanol und Isopropanol, oder einer Mischung dieser Lösemittel,

(iii) Mischen der in Schritt (ii) erhaltenen Dispersion mit wenigstens einem Elastomer, ausgewählt aus Isobutylen/Isopren-Copolymeren wie Butylkautschuk und Butadien/Acrylnitril-Copolymeren in Dispersion oder Suspension in Wasser und/oder in einem Lösemittel, wobei das Lösemittel ein mit den in den Schritten (i) und (ii) verwendeten Lösemitteln mischbares polares organisches Lösemittel sein kann, ausgewählt aus Dimethylsulfoxid (DMSO), N-Methyl-2-pyrrolidon (NMP), Dimethylformamid (DMF), Dimethylacetat (DMAc), Ethylenglycol, Aceton, Alkoholen wie Methanol, Ethanol, Butanol und Isopropanol, oder einer Mischung dieser Lösemittel,

(iv) Aufbringen der in Schritt (iii) erhaltenen Zusammensetzung auf einen Träger, und

(v) Verdampfen der Lösemittel durch Trocknen bei einer Temperatur zwischen 20 und 180°C für eine Dauer zwischen 5 Sekunden und 120 Minuten.

**11.** Verfahren nach Anspruch 10, **dadurch gekennzeichnet, dass** die Kohlenstoffnanoröhren der Erfindung in Schritt (i) in Wasser oder einer Mischung aus Wasser/Dimethylsulfoxid (DMSO) oder einer Mischung aus Wasser/Ethanol dispergiert werden, das PEDOT : PSS in Schritt (ii) in Wasser oder einer Mischung aus Wasser/Dimethylsulfoxid (DMSO) dispergiert wird, und das Elastomer in Schritt (iii) in Wasser dispergiert wird.

**12.** Artikel, **dadurch gekennzeichnet, dass** er ein Substrat enthält, das mit wenigstens einer leitfähigen transparenten Folie oder Beschichtung gemäß einem der Ansprüche 6 bis 9 oder erhalten nach dem Verfahren gemäß einem der Ansprüche 10 oder 11 beschichtet ist.

**13.** Artikel nach Anspruch 12, **dadurch gekennzeichnet, dass** das Substrat ausgewählt ist aus Glas, Metall, Keramik, Leiter- oder Halbleitermaterialien und flexiblen Polymeren.

**14.** Artikel nach Anspruch 13, **dadurch gekennzeichnet, dass** die flexiblen Polymere ausgewählt sind aus Polyethylenterephthalat (PET), Polyethylennaphthalat (PEN) und Polyethersulfon (PES).

**15.** Elektronische Vorrichtung, **dadurch gekennzeichnet, dass** sie wenigstens einen Artikel gemäß einem der Ansprüche 12 bis 14 umfasst.

**16.** Vorrichtung nach Anspruch 15, **dadurch gekennzeichnet, dass** sie ausgewählt ist aus photovoltaischen Zellen, Flüssigkristalldisplays, organischen Leuchtdioden (OLED), Polymer-Leuchtdioden (PLED) und Touchscreens.

**Claims**

**1.** Composition of carbon nanotubes dispersed in poly(3,4-ethylenedioxythiophene) poly(styrenesulfonate) (PEDOT:PSS), said PEDOT:PSS being dispersed or suspended in water and/or in a solvent, **characterised in that** said composition further includes at least one dispersion or suspension of an elastomer selected from among the isobutylene/isoprene copolymers such as butyl rubber, and the butadiene/acrylonitrile copolymers.

**2.** Composition according to claim 1, **characterised in that** the weight ratio between the carbon nanotubes and the PEDOT:PSS is between 1/100 and 50/1, preferably between 1/50 and 5/1.

**3.** Composition according to one of claims 1 or 2, **characterised in that** the carbon nanotubes are present at a rate by weight of between 0.05 and 90%, preferably between 0.1 and 10%, compared to the total dry matter weight of said composition.

**4.** Composition according to one of claims 1 to 3, **characterised in that** the weight ratio between said elastomer and said carbon nanotubes is between 10 and 10,000.

**5.** Composition according to one of claims 1 to 4, **characterised in that** the weight ratio between said elastomer and the PEDOT:PSS is between 1 and 500,000.

**6.** Transparent conductive film or coating, **characterised in that** it results from forming films of or depositing at least one composition of carbon nanotubes as defined according to one of claims 1 to 5.

7. Film or coating according to claim 6, **characterised in that** it has a thickness of between 300 nm and 15 $\mu$m.

8. Film or coating according to one of claims 6 or 7, **characterised in that** it has a total transmission of UV-visible light [300 nm - 900 nm] of at least 30%, for a maximum film thickness of 15 $\mu$m.

9. Film or coating according to one of claims 6 to 8, **characterised in that** it has a surface resistance of between 0.1 and 5000 $\Omega/\square$, and preferably between 0.1 and 1000$\Omega/\square$.

10. Method for preparing a transparent conductive film or coating as defined according to one of claims 6 to 9, **characterised in that** it includes the following steps:

   (i) dispersion of the carbon nanotubes in water and/or in a solvent, said solvent being able to be a polar organic solvent selected from among dimethylsulfoxyde (DMSO), N-methyl-2-pyrrolidone (NMP), dimethylformamide (DMF), dimethylacetate (DMAc), ethylene glycol, acetone, alcohols such as methanol, ethanol, butanol and isopropanol, or a mixture of said solvents,
   (ii) mixture of the dispersion obtained in step (i) with poly(3,4-ethylenedioxythiophene) poly(styrenesulfonate) (PEDOT:PSS) dispersed or suspended in water and/or in a solvent, said solvent being able to be a polar organic solvent miscible with the solvent used in step (i), selected from among dimethylsulfoxyde (DMSO), N-methyl-2-pyrrolidone (NMP), dimethylformamide (DMF), dimethylacetate (DMAc), ethylene glycol, acetone, alcohols such as methanol, ethanol, butanol and isopropanol, or a mixture of said solvents,
   (iii) mixture of the dispersion obtained in step (ii) with at least one elastomer selected from among the isobutylene/isoprene copolymers such as butyl rubber, and the butadiene/acrylonitrile copolymers dispersed or suspended in water and/or in a solvent, said solvent being able to be a polar organic solvent miscible with the solvents used in steps (i) and (ii), selected from among dimethylsulfoxyde (DMSO), N-methyl-2-pyrrolidone (NMP), dimethylformamide (DMF), dimethylacetate (DMAc), ethylene glycol, acetone, alcohols such as methanol, ethanol, butanol and isopropanol, or a mixture of said solvents,
   (iv) application of the composition obtained in step (iii) to a support, and
   (v) evaporation of the solvents by drying at a temperature between 20 and 180°C for a period of between 5 seconds and 120 minutes.

11. Method according to claim 10, **characterised in that** the carbon nanotubes of the invention are dispersed in water or in a water/dimethylsulfoxide (DMSO) mixture or in a water/ethanol mixture in step (i), the PEDOT:PSS is dispersed in water or in a water/dimethylsulfoxide (DMSO) mixture in step (ii) and the elastomer is dispersed in water in step (iii).

12. Article, **characterised in that** it includes a substrate coated with at least one transparent conductive film or coating as defined according to one of claims 6 to 9 or obtained according to the method as defined in one of claims 10 or 11.

13. Article according to claim 12, **characterised in that** the substrate is chosen from among glass, metal, ceramic, conductive or semi-conductive materials and flexible polymers.

14. Article according to claim 13, **characterised in that** said flexible polymers are selected from among polyethylene terephthalate (PET), polyethylene naphthalate (PEN) and polyethersulfone (PES).

15. Electronic device, **characterised in that** it includes at least one item as defined according to one of claims 12 to 14.

16. Device according to claim 15, **characterised in that** it is chosen from among photovoltaic cells, liquid crystal displays, organic light-emitting diodes (OLED), polymer light-emitting diodes (PLED), and touch screens,

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2006137846 A
- US 6984341 B
- US 5766515 A